Europäisches Patentamt

**European Patent Office**

Office européen des brevets

(19)

(11) Numéro de publication : **0 095 969**
**B1**

# (12) FASCICULE DE BREVET EUROPÉEN

(45) Date de publication du fascicule du brevet :
**09.11.88**

(21) Numéro de dépôt : **83401010.0**

(22) Date de dépôt : **20.05.83**

(51) Int. Cl.⁴ : **H 01 J 37/073**

(54) **Canon à électrons avec cathode à émission de champ et lentille magnétique.**

(30) Priorité : **24.05.82 FR 8208952**

(43) Date de publication de la demande :
**07.12.83 Bulletin 83/49**

(45) Mention de la délivrance du brevet :
**09.11.88 Bulletin 88/45**

(84) Etats contractants désignés :
**DE GB NL**

(56) Documents cités :
**DE-C- 857 254**
**US-A- 3 509 503**
**US-A- 3 862 419**
**OPTIK, vol. 57, no. 3, décembre 1980, pages 401-419, Stuttgart, DE. M. TROYON: "High current efficiency field emission gun system incorporating a preaccelerator magnetic lens. Its use in CTEM"**
**PROCEEDINGS OF THE SYMPOSIUM ON ELECTRON AND ION BEAM SCIENCE AND TECHNOLOGY, vol. 78-5, 1979, pages 3-9, Princeton, USA. H.P. KUO et al.: "A high brightness high current field emission electron probe"**
**Le dossier contient des informations techniques présentées postérieurement au dépôt de la demande et ne figurant pas dans le présent fascicule.**

(73) Titulaire : **UNIVERSITE DE REIMS CHAMPAGNE ARDENNE**
**23, rue Boulard**
**F-51100 Reims (FR)**

(72) Inventeur : **Troyon, Michel**
**6 avenue de l'Europe**
**F-51100 Reims (FR)**

(74) Mandataire : **Martin, Jean-Jacques et al**
**Cabinet REGIMBEAU 26, Avenue Kléber**
**F-75116 Paris (FR)**

## Description

L'invention concerne les canons à électrons, qui servent notamment dans les microscopes électroniques de tous types.

D'une manière générale, ces canons à électrons comprennent une cathode à émission de champ, des organes de focalisation et des organes accélérateurs comportant au moins une anode portée à un potentiel choisi.

Le brevet britannique 1 292 221, propose une focalisation par lentille magnétique, qu'il semble difficile d'utiliser aux fortes valeurs de la tension d'accélération.

En fait, les canons à émission de champ actuels sont à focalisation électrostatique, avec les inconvénients d'aberration que cela comporte.

Dans la solution proposée conformément à l'invention, le canon à électrons comprend une cathode à émission de champ, des organes de focalisation à lentille magnétique placés au voisinage de la cathode et des organes accélérateurs comportant au moins une anode portée à un potentiel choisi. La lentille magnétique est portée au potentiel extracteur des électrons et comprend un bobinage, un circuit magnétique et une pièce polaire en deux parties disposées coaxialement à la bobine du côté de la cathode à émission de champ et délimitant un entrefer, et dont la première partie est munie d'un orifice axial d'entrée des électrons tandis que la seconde partie est munie d'un orifice axial de sortie des électrons. Le canon à électrons objet de l'invention est remarquable en ce que l'orifice d'entrée des électrons possède un diamètre inférieur à celui de l'orifice de sortie des électrons, ces diamètres étant tous deux inférieurs à environ 10 mm, en ce que l'entrefer entre les deux parties de la pièce polaire est, selon l'axe de la bobine, inférieur à 3 mm environ, et en ce que la distance entre le plan médian de cet entrefer et l'extrémité proximale de la cathode est inférieure à 5 mm environ.

En pratique, il est souhaitable que l'orifice d'entrée possède un diamètre inférieur à 4 mm, de préférence compris entre 0,5 et 3,5 mm et l'orifice de sortie possède un diamètre compris dans un intervalle qui fasse de 3 à 8 mm environ, ou mieux de 4 à 6 mm.

De son côté l'entrefer est au plus égal à 1,5 mm environ. Et la distance entre le plan médian de l'entrefer et l'extrémité proximale de la cathode est avantageusement comprise entre 1,5 et 3 mm.

Selon une autre caractéristique de l'invention, intéressante à ajouter aux caractéristiques précédentes, on prévoit une électrode intermédiaire qui entoure au moins la lentille magnétique tout en laissant passer les électrons sur l'axe de celle-ci, et le point image donné de la cathode par la lentille magnétique se place sensiblement au niveau de l'ouverture de l'électrode intermédiaire, du côté de la lentille magnétique qui est opposé à la cathode. Il est très avantageux aussi que l'électrode intermédiaire entoure également la cathode de façon pratiquement complète, et l'alimentation.

D'autres caractéristiques et avantages de l'invention apparaîtront à la lecture de la description détaillée qui va suivre, ainsi que sur les dessins annexés, sur lesquels :

- la figure 1 illustre schématiquement sous forme d'une vue en coupe axiale la structure générale d'un canon à électrons avec focalisation magnétique ;

- la figure 2 illustre plus en détail les éléments essentiels du canon à électrons selon l'invention, à savoir sa cathode à émission de champ et sa lentille de focalisation ainsi qu'une électrode auxiliaire, et ce dans le mode de réalisation préférentiel de l'invention ; et

- la figure 3 illustre plus en détail la coopération de la pièce polaire 60 de la lentille magnétique avec la cathode à émission de champ 20.

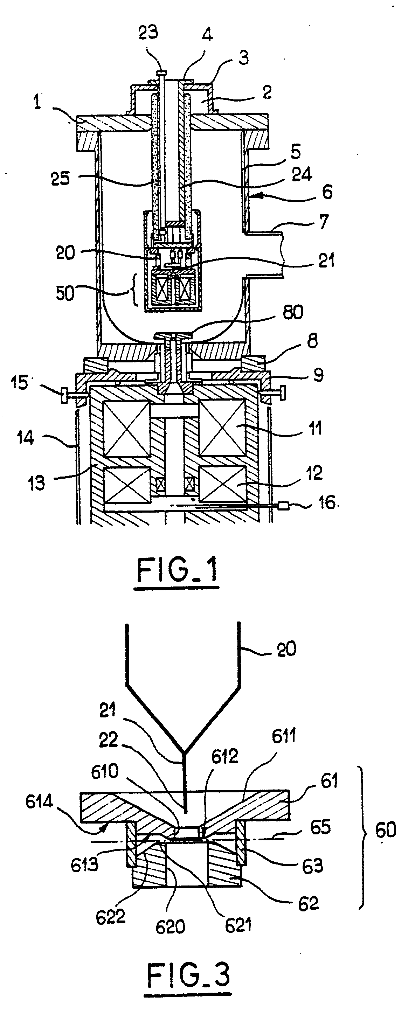

Sur la figure 1, on distingue en partie supérieure un flasque 1; qui est surmonté d'un couvercle 3 formant un réservoir 2 à hexafluorure de soufre, milieu utilisé préférentiellement en ambiance de haute tension. Le réservoir et le flasque sont traversés axialement par un manchon support 24, qui est par exemple en PLEXIGLAS, et peut contenir des câbles d'alimentation électrique vers l'intérieur des dispositifs.

Au-dessous du flasque 1, une enceinte 6, doublée intérieurement par un blindage en mu-métal 5 définit le logement pour la cathode à émission de champ et ses organes de focalisation. L'enceinte 6 est percée d'un large orifice 7, qui permet sa relation avec un organe générateur de vide très poussé, par exemple une pompe ionique avec sublimation de titane.

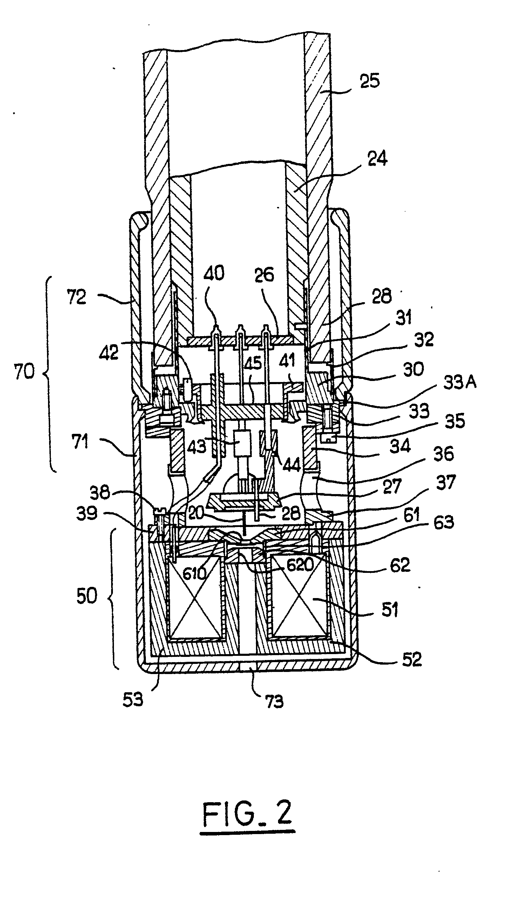

Intérieurement donc, le manchon 24 est entouré d'une gaine isolante en alumine 25, qui ne va que jusqu'à l'intérieur du réservoir 2. La gaine 25 forme « passage haute tension » et réalise en même temps l'étanchéité au vide. La gaine isolante 25 sert de support (fig. 2) tout d'abord à la cathode à émission de champ 20, dont le filament actif est notée 21, ensuite à la lentille magnétique 50, et enfin à une électrode intermédiaire périphérique 70 qui entoure cet ensemble.

Les électrons ainsi produits vont sortir verticalement en direction du bas, vers l'anode 80 (fig. 1). En dessous, par l'intermédiaire d'un dispositif de cales 8 est maintenu un support de fixation 9, qui retient d'une manière ajustable en position en particulier par des vis 15, un ensemble condenseur formé d'une première bobine de condenseur 11, suivie d'une seconde bobine de condenseur 12, après quoi un dispositif 16 permet de former diaphragme ajustable. Cet ensemble est entouré d'un blindage 14.

La structure des éléments formant condenseur est considérée comme connue de l'homme de l'art et ne sera pas décrite plus en détail.

On se référera maintenant à la figure 2, où l'on retrouve le manchon de PLEXIGLAS 24 entouré par la gaine isolante 25.

La gaine isolante 25 se prolonge en périphérie par une bague mince 32, à laquelle se trouve suspendu un dispositif 30, annulaire, de forme un peu complexe, car il sert de support à son tour à toutes les parties électriques. Par ailleurs, la pièce 30 comporte une bague interne 31, qui sert de guidage en rotation pour l'introduction du manchon 24 et l'établissement des contacts électriques.

Intérieurement, la pièce annulaire 30 soutient par l'intermédiaire d'une suspension élastique une autre bague interne 41, qui supporte un disque isolant 45, étanche au vide, et servant à son tour à la suspension de la cathode 20, par l'intermédiaire des organes de traversée électrique tels que 43 et 44. Ce disque 45 se trouve en regard d'un disque homologue 26, placé en partie basse dans le manchon de PLEXIGLAS 24, dont il reçoit les différentes traversées électriques, telles que 40.

La cathode se compose elle-même d'une embase support 27, en matière isolante telle que de l'alumine.

Cette embase 27 est à son tour munie de traversées électriques, dont on voit un exemple en 28. Cette traversée sert à des fins d'alimentation auxiliaire, ainsi que pour assurer une meilleure suspension de l'embase 27. Des traversées du même genre, mais placées dans un plan perpendiculaire à la figure supportent le filament de cathode 20, dont la forme est mieux illustrée sur la figure 3, qui est une coupe dans le plan perpendiculaire à la figure 2.

On notera que des vis telles que 42 permettent le déplacement de l'ensemble de la cathode par rapport au support, ce qui permet d'ajuster précisément la position du filament de cathode 20, ce qui peut se faire même en fonctionnement, par l'intermédiaire de tiges en Téflon telles que celle qui est illustrée en 23 sur la figure 1.

En second lieu, la pièce 30 supporte une autre bague 33, qui à son tour reçoit par fixation inférieure à l'aide de vis telles que 35 un cylindre 34 en alumine, percé d'orifices tels que 36. En partie basse, ce cylindre reçoit en 37 l'ensemble du dispositif de focalisation magnétique. Cet ensemble comprend, en dessous d'une plaque métallique 39, un circuit magnétique 53, qui loge intérieurement un bobinage 51, dans une carcasse étanche 52. De manière connue, le circuit magnétique est interrompu du côté de l'axe de la bobine 51, là où arrive le filament de cathode 20. A ce niveau, le circuit magnétique est interrompu par un entrefer compris entre deux pièces polaires notées 61 et 62, et maintenue en position relative par une entretoise 63, cet ensemble apparaissant de façon plus détaillée sur la figure 3.

Sur la figure 2, on notera également que la traversée électrique 40 permet l'alimentation de la bobine, ainsi que l'amenée de la haute tension sur l'ensemble du dispositif de bobine, l'un des fils allant vers la vis de fixation 38, tandis que l'autre va directement vers le bobinage 51.

La bague 33 comporte encore un épaulement radial vers l'extérieur noté 33A, qui sert de support à une électrode intermédiaire périphérique désignée globalement par la référence 70. Cette électrode est en fait en deux parties 71 et 72, qui sont maintenues en place par vissage l'une sur l'autre, tout en enserrant l'épaulement 33A. La pièce inférieure 71 est munie en partie basse d'un orifice 73 qui vient se placer sur l'axe de la bobine.

Si l'on se reporte maintenant à la figure 3, on voit que, selon l'une des caractéristiques importantes de l'invention, l'ensemble polaire 60 est dissymétrique. En effet, il comporte un pôle supérieur 61 qui est percé d'un trou 610 dont le diamètre est de préférence compris entre 1,5 et 3 mm. Cependant, des valeurs plus importantes peuvent être envisagées dans certains cas, comme on l'a déjà indiqué. Le pôle supérieur 61 est assujetti au pôle inférieur 62 par l'intermédiaire d'une entretoise frettée en titane 63, et le diamètre du trou 620 du pôle inférieur est de l'ordre de 5 mm. Comme précédemment indiqué, des valeurs un peu différentes peuvent être envisagées.

Enfin, la valeur de l'entrefer est de l'ordre du millimètre. L'entrefer se mesure ici entre le plan inférieur du pôle supérieur 61 et le plan supérieur du pôle inférieur 62.

On notera également le trait d'axe 65 qui définit le plan médian de la pièce polaire, ou de l'entrefer.

En pratique, le pôle supérieur 61 ou première partie de l'ensemble polaire comporte supérieurement un évidement tronconique 611 qui se raccorde avec l'orifice 610, et permet l'introduction du filament de cathode 20 le plus près possible de l'orifice. (Le filament de cathode est considérablement agrandi par rapport à la taille de la pièce polaire).

En partie basse, le pôle supérieur 61 comporte un plateau 612, qui s'étend radialement perpendiculairement à l'axe, et entoure l'orifice 610. Ce plateau 612 est suivi consécutivement de deux décrochements 613 et 614 qui sont également plats, mais se placent en retrait par rapport à l'autre pôle 62, et sont raccordés entre eux par une zone cylindrique axiale qui sert d'appui à l'entretoise 63.

De son côté, le second pôle 62 comporte lui aussi un plateau 621 qui s'étend radialement perpendiculairement à l'axe et entoure l'orifice 620. Ce plateau est suivi d'une zone en décrochement 622 qui se termine encore une fois par un épaulement assurant le placement de l'entretoise de titane 63.

Il est souhaitable d'utiliser la lentille magnétique en focale courte, ce qui implique que l'extrémité proximale 22 de la partie axiale 21 du filament de cathode 20 soit placée à une distance d'environ 1,5 à 3 mm du plan médian 65 de l'entrefer de la lentille magnétique.

La présente invention permet d'obtenir de faibles valeurs des coefficients d'aberrations sphérique $C_s$ et chromatique $C_c$, à savoir de l'ordre de quelques millimètres. On a pu obtenir par exemple un coefficient $C_s$ de 3 mm et un coefficient $C_c$

de 1,8 mm.

Il en résulte la possibilité d'obtenir un courant de sonde électronique beaucoup plus important, compte tenu de la diaphragmation. Le courant de sonde électronique est au minimum 4 fois plus important que ceux que l'on obtient avec les canons à émission de champ et lentille électrostatique actuellement en service, et ceci pour des sondes de diamètre supérieur à environ 10 nanomètres.

Les performances pratiques d'un canon déjà réalisé sont les suivantes :
- très grande brillance : $10^8$ A · $cm^{-2}$ pour une tension d'accélération de 100 kV.
- fort courant de faisceau, à savoir jusqu'à $10^{-6}$ A dans une sonde de 200 nm.
- ultra vide, qui permet une pression inférieure à $1,33 \cdot 10^{-8}$ Pa ($10^{-10}$) Torr.
- tension d'accélération jusqu'à 120 kV sur un seul étage.

La disposition proposée selon la présente invention possède en outre l'avantage d'obtenir a priori une bonne stabilité du point de focalisation aval dans la lentille, c'est-à-dire de la source électronique image, qui est donnée de la cathode par la lentille magnétique.

De préférence, on prévoit l'électrode intermédiaire 70 déjà citée, qui est placée immédiatement après la lentille magnétique, et présente en 73 un orifice sur l'axe de celle-ci. En excitant la bobine de façon que le point de focalisation aval se place au niveau de cet orifice 73 ou près de celui-ci, on augmente encore considérablement la stabilité de la position de la source électronique d'image. Si par exemple la tension d'accélération finale est notée $V_i$ et la tension d'extraction des électrons est $V_o$, le rapport de tension $V_i/V_o$ peut varier de 4 à 50 sans que la position de la source électronique image ne varie de plus que 5 mm le long de l'axe optique.

Par ailleurs, en faisant remonter, comme indiqué en 72, l'électrode intermédiaire largement au-dessus de la cathode, on protège celle-ci contre les claquages éventuels de la haute tension.

L'invention peut servir dans toutes les applications des canons à électrons, en particulier lorsqu'on a besoin d'un courant électronique intense sur un diamètre de sonde inférieur à 0,2 micromètre. Plus particulièrement, les domaines d'application de l'invention sont : la microscopie électronique classique et à balayage, la microanalyse par rayons X, la spectroscopie Auger, et la microlithographie.

## Revendications

1. Canon à électrons comprenant une cathode à émission de champ (20), des organes de focalisation à lentille magnétique (50) placés au voisinage de la cathode et des organes accélérateurs comportant au moins une anode (80) portée à un potentiel choisi, ladite lentille magnétique étant portée au potentiel extracteur des électrons et comprenant un bobinage (51), un circuit magnétique (52) et une pièce polaire (60) en deux parties (61, 62) disposées coaxialement à la bobine du côté de la cathode (20) à émission de champ et délimitant un entrefer, et dont la première partie (61) est munie d'un orifice axial d'entrée des électrons (610) tandis que la seconde partie (62) est munie d'un orifice axial de sortie des électrons (620), caractérisé par le fait que l'orifice d'entrée des électrons possède un diamètre inférieur à celui de l'orifice de sortie des électrons (620), ces diamètres étant tous deux inférieurs à environ 10 mm, que l'entrefer entre les deux parties (61, 62) de la pièce polaire est, selon l'axe de la bobine, inférieur à 3 mm environ, et que la distance entre le plan médian (65) de cet entrefer et l'extrémité proximale de la cathode (22) est inférieure à 5 mm environ.

2. Canon à électrons selon la revendication 1, caractérisé par le fait que l'orifice d'entrée (610) possède un diamètre inférieur à 4 mm, et que l'orifice de sortie (620) possède un diamètre compris entre 3 et 8 mm environ.

3. Canon à électrons selon la revendication 2, caractérisé par le fait que l'orifice d'entrée (610) possède un diamètre compris entre 0,5 et 3,5 mm et que l'orifice de sortie (620) possède un diamètre compris entre 4 et 6 mm.

4. Canon à électrons selon l'une des revendications 1 à 3, caractérisé par le fait que l'entrefer est au plus égal à 1,5 mm environ.

5. Canon à électrons selon l'une des revendications 1 à 4, caractérisé par le fait que la distance entre le plan médian de l'entrefer (65) et l'extrémité proximale (22) de la cathode est comprise entre 1,5 et 3 mm.

6. Canon à électrons selon l'une des revendications 1 à 5, caractérisé par le fait qu'il comporte une électrode intermédiaire (70 ; 71, 72) qui entoure au moins la lentille magnétique tout en laissant passer les électrons sur l'axe de celle-ci, et par le fait que le point image donné de la cathode (20) par la lentille magnétique (50) se place sensiblement au niveau de l'ouverture (73) de l'électrode intermédiaire, du côté de la lentille magnétique qui est opposé à la cathode.

7. Canon à électrons selon la revendication 6, caractérisé par le fait que l'électrode intermédiaire (71, 72) entoure également la cathode de façon pratiquement complète.

8. Canon à électrons selon l'une des revendications 1 à 7, caractérisé par le fait que la partie (61) proximale de la pièce polaire à l'égard de la cathode définit côté cathode un creux tronconique (611) se raccordant audit orifice d'entrée (610), et du côté opposé, au voisinage de l'orifice de sortie et vers celui-ci, une surélévation axiale plate (612) de diamètre sensiblement égal à celui de l'orifice de sortie, suivie latéralement de décrochements en retrait (613, 614), et par le fait que la partie distale de la pièce polaire comporte, du côté de l'orifice d'entrée (610), un plateau radial (621) un peu plus large que ladite surélévation, et centré sur l'orifice de sortie (620), ce plateau radial (621) se raccordant à une zone (622) en retrait à l'égard de ladite partie proximale (61),

tandis qu'une entretoise (63) est montée entre la zone en retrait (622) de la partie distale et le décrochement (613, 614) en retrait de la partie proximale (61).

## Claims

1. An electron gun comprising a field emission cathode (20), magnetic lens focusing means (50) disposed near the cathode, and accelerator means comprising at least one anode (80) brought to a selected potential, said magnetic lens being brought to the electron extracting potential and comprising a winding (51), a magnetic circuit (52) and a pole piece (60) consisting of two parts (61, 62) disposed coaxially to the coil on the field emission cathode (20) side and defining an air gap, the first part (61) being provided with an axial electron entry port (610) while the second part (62) is provided with an axial electron exit port (620), characterised in that the electron entry port is of smaller diameter than the electron exit port (620), said diameters both being less than about 10 mm, in that the air gap between the two parts (61, 62) of the pole piece along the coil axis is less than about 3 mm, and in that the distance between the median plane (65) of said air gap and the proximal end of the cathode (22) is less than about 5 mm.

2. An electron gun according to claim 1, characterised in that the entry port (610) has a diameter less than 4 mm and the exit port (620) has a diameter of between about 3 and 8 mm.

3. An electron gun according to claim 2, characterised in that the entry port (610) has a diameter of between 0.5 and 3.5 mm and the exit port (620) has a diameter of between 4 and 6 mm.

4. An electron gun according to any one of claims 1 to 3, characterised in that the air gap is about 1,5 mm maximum.

5. An electron gun according to any one of claims 1 to 4, characterised in that the distance between the median plane of the air gap (65) and the proximal end (22) of the cathode is between 1,5 and 3 mm.

6. An electron gun according to any one of claims 1 to 5, characterised in that it comprises an intermediate electrode (70 ; 71, 72) which surrounds at least the magnetic lens while allowing the electrons to pass on the axis thereof, and in that the image point given of the cathode (20) by the magnetic lens (50) is situated substantially at the level of the intermediate electrode aperture (73) on the side of the magnetic lens which is remote from the cathode.

7. An electron gun according to claim 6, characterised in that the intermediate electrodes (71, 72) also surrounds the cathode practically completely.

8. An electron gun according to any one of claims 1 to 7, characterised in that the proximal part (61) of the pole piece with respect to the cathode defines on the cathode side a frusto-conical cavity (611) connected to the entry port (610) and, on the opposite side, near the exit port and towards the latter, a flat axial raised portion (612) of a diameter substantially equal to that of the exit port, followed laterally by offset set-back portions (613, 614) and in that the distal part of the pole piece comprises, on the entry port (610) side, a radial plateau (621) slightly larger than said raised portion, and centred on the exit port (620) said radial plateau (621) being connected to a zone (622) offset with respect to the said proximal part (61), while a strut (63) is mounted between the zone (622) offset from the distal part and the set-back portion (613, 614) offset from the proximal part (61).

## Patentansprüche

1. Elektronenkanone, mit einer Feldemissionskathode (20), mit an der Kathode angeordneten magnetischen Linsen (50) als Fokussierungsinstrumente und mit Beschleunigern, welche wenigstens eine auf ein bestimmtes Potential gebrachte Anode (80) aufweisen, wobei die magnetische Linse auf das Auslösepotential der Elektronen gebracht ist und aus einer Wicklung (51), einem magnetischen Schaltkreis (52) und einem aus zwei Teilen (61, 62) bestehenden Polschuh (60) besteht, wobei die zwei Teile koaxial zur Wicklung bei der Feldemissionskathode (20) angeordnet sind und einen Eisenspalt begrenzen, und wobei der erste Teil (61) mit einem axialen Elektroneneinlaß (610) versehen ist, während de zweite Teil (62) mit einem axialen Elektronenauslaß (620) versehen ist, dadurch gekennzeichnet, daß der Elektroneneinlaß einen geringeren Durchmesser als der Elektronenauslaß (620) hat, wobei beide Durchmesser kleiner als etwa 10 mm sind, daß der Eisenspalt zwischen den beiden Teilen (61, 62) des Polschuhs gemäss der Achse der Wicklung kleiner als etwa 3 mm ist und daß der Abstand zwischen der Mittelebene (65) dieses Eisenspaltes und dem nahegelegenen Ende (22) der Kathode kleiner als etwa 5 mm ist.

2. Elektronenkanone nach Anspruch 1, dadurch gekennzeichnet, daß der Einlaß (610) einen Durchmesser kleiner als 4 mm und daß der Auslaß (620) einen Durchmesser zwischen einschließlich 3 und 8 mm hat.

3. Elektronenkanone nach Anspruch 2, dadurch gekennzeichnet, daß der Einlaß (610) einen Durchmesser zwischen einschließlich 0,5 und 3,5 mm und daß der Auslaß einen Durchmesser zwischen einschließlich 4 und 6 mm hat.

4. Elektronenkanone nach einem der Ansprüche 1 bis 3, gekennzeichnet, daß der Eisenspalt höchstens 1,5 mm breit ist.

5. Elektronenkanone nach einem der Ansprüche 1 bis 4, dadurch gekennzeichnet, daß der Abstand zwischen der Mittelebene (65) des Eisenspaltes und dem nahegelegenen Ende (22) der Kathode zwischen einschließlich 1,5 und 3 mm beträgt.

6. Elektronenkanone nach einem der Ansprüche 1 bis 5, dadurch gekennzeichnet, daß sie eine Zwischenelektrode (70 ; 71, 72) aufweist, die wenigstens die magnetische Linse umgibt und die Elektronen auf deren Achse vorbeifliegen läßt, und daß der von der Kathode (20) durch die magnetische Linse (50) erzeugte Bildpunkt sich genau auf der Höhe der Mündung (73) der Zwischenelektrode einstellt, und zwar auf der Seite der magnetischen Linse, die der Kathode gegenüberliegt.

7. Elektronenkanone nach Anspruch 6, dadurch gekennzeichnet, daß die Zwischenelektrode (71, 72) auch die Kathode praktisch vollständig umgibt.

8. Elektronenkanone nach einem der Ansprüche 1 bis 7, dadurch gekennzeichnet, daß das der Kathodenseite nahegelegene Teil (61) des Polschuhs bei der Kathode eine sich an den Einlaß (610) anschließende kegelstumpfförmige Vertiefung (611) und auf der gegenüberliegenden Seite beim Auslaß und auf diesen hin gerichtet ein flacher axialer Vorsprung (612) mit gleichem Durchmesser wie der Auslaß, an welchen sich seitlich und zurückversetzte Absätze (613, 614) anschließen, definiert, und daß das entfernt liegende Teil des Polschuhs beim Einlaß (610) eine radiale Scheibe (621) etwas größer als der Vorsprung und über dem Auslaß (620) zentriert aufweist, die sich an einen zurückliegenden Bereich (622) beim nahegelegenen Teil (61) anschließt, während ein Distanzstück (63) zwischen dem zurückliegenden Bereich (622) des entfernt liegenden Teils und den versetzten Absätzen (613, 614) des nahegelegenen Teils angebracht ist.

FIG.1

FIG.3

FIG. 2